# EUROPÄISCHE PATENTSCHRIFT

(11) **EP 2 834 852 B1**
(45) Veröffentlichungstag und Bekanntmachung des Hinweises auf die Patenterteilung: **25.12.2019**
(21) Anmeldenummer: 13705161.1
(22) Anmeldetag: 19.02.2013
(51) Int. Cl.: H01L 31/0224, H01L 31/0749, H01L 31/032

(54) **MEHRSCHICHT-RÜCKELEKTRODE FÜR EINE PHOTOVOLTAISCHE DÜNNSCHICHTSOLARZELLE, VERWENDUNG DERSELBEN FÜR DIE HERSTELLUNG VON DÜNNSCHICHTSOLARZELLEN UND -MODULEN, PHOTOVOLTAISCHE DÜNNSCHICHTSOLARZELLEN UND -MODULE ENTHALTEND DIE MEHRSCHICHT-RÜCKELEKTRODE SOWIE EIN VERFAHREN ZU DEREN HERSTELLUNG**
MULTI-LAYER BACK ELECTRODE FOR A PHOTOVOLTAIC THIN-FILM SOLAR CELL, USE OF THE SAME FOR PRODUCING THIN-FILM SOLAR CELLS AND MODULES, PHOTOVOLTAIC THIN-FILM SOLAR CELLS AND MODULES CONTAINING THE MULTI-LAYER BACK ELECTRODE AND METHOD FOR THE PRODUCTION THEREOF
ÉLECTRODE ARRIÈRE MULTICOUCHE POUR UNE CELLULE PHOTOVOLTAÏQUE EN COUCHES MINCES, UTILISATION DE CETTE ÉLECTRODE POUR LA FABRICATION DE CELLULES ET DE MODULES SOLAIRES EN COUCHES MINCES, CELLULES ET MODULES PHOTOVOLTAÏQUES EN COUCHES MINCES DOTÉS DE L'ÉLECTRODE ARRIÈRE MULTICOUCHE, ET PROCÉDÉ DE FABRICATION CORRESPONDANT

(30) Priorität: 02.04.2012 DE 102012205375
(43) Veröffentlichungstag der Anmeldung: 11.02.2015
(73) Patentinhaber: Probst, Volker, 14089 Berlin (DE)
(72) Erfinder: Probst, Volker, 14089 Berlin (DE)
(74) Vertreter: Metten, Karl-Heinz
(86) Internationale Anmeldenummer: PCT/EP2013/053224
(87) Internationale Veröffentlichungsnummer: WO 2013/149757

(56) Entgegenhaltungen:
- EP-A1- 1 833 096
- WO-A1-2005/088731
- US-A1- 2005 074 915
- US-A1- 2012 042 929
- US-A1- 2012 055 543
- ORGASSA K ET AL: "Alternative back contact materials for thin film Cu(In,Ga)Se2 solar cells", THIN SOLID FILMS, ELSEVIER-SEQUOIA S.A. LAUSANNE, CH, Bd. 431-432, 1. Mai 2003 (2003-05-01), Seiten 387-391, XP004428673, ISSN: 0040-6090, DOI: 10.1016/S0040-6090(03)00257-8 in der Anmeldung erwähnt
- T. WADA ET AL.: "Chemical and Structural Characterization of Cu(In,Ga)Se2/Mo Interface in Cu(In,Ga)Se2 Solar Cells", JPN. J. APPL. PHYS., Bd. 35, Nr. 10A, 1996, Seiten 1253-1256, XP002696719,
- PATRICK BLÖSCH ET AL: "Comparative Study of Different Back-Contact Designs for High-Efficiency CIGS Solar Cells on Stainless Steel Foils", IEEE JOURNAL OF PHOTOVOLTAICS, I E E E, US, Bd. 1, Nr. 2, 1. Oktober 2011 (2011-10-01) , Seiten 194-199, XP011390833, ISSN: 2156-3381, DOI: 10.1109/JPHOTOV.2011.2166589 in der Anmeldung erwähnt

## Beschreibung

Die vorliegende Erfindung betrifft eine Mehrschicht-Rückelektrode für eine photovoltaische Dünnschichtsolarzelle, die Verwendung dieser Mehrschicht-Rückelektrode für die Herstellung von Dünnschichtsolarzellen und Dünnschichtsolarmodulen, photovoltaische Dünnschichtsolarzellen und -module enthaltend die erfindungsgemäße Mehrschicht-Rückelektrode sowie ein Verfahren zur Herstellung photovoltaischer Dünnschichtsolarzellen und -module.

Geeignete Photovoltaik-Solarmodule umfassen einerseits kristalline und amorphe Siliziumsolarmodule und andererseits sogenannte Dünnschichtsolarmodule. Bei letzteren kommt im Allgemeinen eine IB-IIIA-VIA-Verbindungshalbleiterschicht, eine sogenannte Chalkopyrit-Halbleiterabsorberschicht zum Einsatz. Bei diesen Dünnschichtsolarmodulen liegt auf einem Glassubstrat üblicherweise eine Molybdänrückelektrodenschicht auf. Diese wird in einer Verfahrensvariante mit einer Kupfer und Indium sowie gegebenenfalls Gallium umfassenden Precursor-Metalldünnschicht versehen und anschließend in Gegenwart von Schwefelwasserstoff und/oder Selenwasserstoff bei erhöhten Temperaturen zu einem so genannten CIS- bzw. CIGS-System umgesetzt.

Um einen akzeptablen Wirkungsgrad zuverlässig erreichen zu können, ist in der Regel schon bei der Wahl und Herstellung der Rückelektrodenschicht besondere Obacht erforderlich. Beispielsweise hat die Rückelektrodenschicht über eine hohe Querleitfähigkeit zu verfügen, um eine verlustarme Serienverschaltung sicherzustellen. Auch sollten aus dem Substrat und/oder der Halbleiterabsorberschicht migrierende Substanzen keinen Einfluss auf die Qualität und Funktionsweite der Rückelektrodenschicht haben. Darüber hinaus muss das Material der Rückelektrodenschicht eine gute Anpassung an das thermische Ausdehnungsverhalten von Substrat und den darüber liegenden Schichten aufweisen, um Mikrorisse zu vermeiden. Schließlich sollte auch die Haftung auf der Substratoberfläche allen gängigen Nutzungsanforderungen genügen.

Zwar ist es möglich, zu guten Wirkungsgraden über den Einsatz von besonders reinem Rückelektrodenmaterial zu gelangen, allerdings gehen hiermit regelmäßig unverhältnismäßig hohe Produktionskosten einher. Zudem führen die vorangehend genannten Migrations- bzw. insbesondere Diffusionsphänome unter den üblichen Produktionsbedingungen nicht selten zu einer signifikanten Verunreinigung des Rückelektrodenmaterials.

Zu einer Solarzelle mit morphologisch gut ausgebildeter Absorberschicht und guten Wirkungsgraden soll man gemäß der DE 44 42 824 C1 dadurch gelangen, dass man die Chalkopyrit-Halbleiterabsorberschicht mit einem Element aus der Gruppe Natrium, Kalium und Lithium in einer Dosis von 10¹⁴ bis 10¹⁶ Atomen/cm² dotiert und gleichzeitig eine Diffusionssperrschicht zwischen dem Substrat und der Halbleiterabsorberschicht vorsieht. Alternativ wird vorgeschlagen, ein alkalifreies Substrat zu verwenden, sofern auf eine Diffusionssperrschicht verzichtet werden soll.

Blösch et al. (Thin Solid Films 2011) schlagen vor, bei Verwendung einer Polyimidsubstratfolie ein Schichtsystem aus Titan, Titannitrid und Molybdän zu verwenden, um gute Haftungseigenschaften und ein zufriedenstellendes thermisches Eigenschaftsprofil zu erhalten. Blösch et al. (IEEE, 2011, Vol. 1, Nr. 2, Seiten 194 bis 199) schlagen für die Verwendung flexibler Dünnschichtsolarzellen ferner den Einsatz einer Edelstahlsubstratfolie vor, auf welche zunächst zwecks Verbesserung der Haftung eine dünne Titanschicht aufgebracht wird. Zufriedenstellende Ergebnisse wurden mit solchen CIGS-Dünnschichtsolarzellen erzielt, welche mit einer Titan/Molybdän/Molybdän-Dreifachlage ausgestattet waren. Verbesserte Dünnschichtsolarzellen werden auch mit der technischen Lehre der WO 2011/123869 A2 angestrebt. Die darin offenbarte Solarzelle umfasst ein Natriumglassubstrat, eine Molybdän-Rückelektrodenschicht, eine CIGS-Schicht, eine Pufferschicht, eine Schicht aus intrinsischem Zinkoxid und eine Schicht aus mit Aluminium dotiertem Zinkoxid. Ein erster Trenngraben erstreckt sich über die Molybdänschicht, die CIGS-Schicht und die Pulverschicht, ein zweiter Trenngraben beginnt oberhalb der Molybdänschicht. Ein isolierendes Material wird in bzw. auf dem ersten Trenngraben abgeschieden, und eine Frontelektrodenschicht ist schräg auf die Solarzelle, einschließlich des ersten Trenngrabens, abzuscheiden. Auf diese Weise sollen Dünnschichtsolarzellen mit verbesserter Lichtausbeute erhalten werden. Die US 2004/014419 A1 ist bestrebt, eine Dünnschichtsolarzelle zur Verfügung zu stellen, deren Molybdän-Rückelektrodenschicht über einen verbesserten Wirkungsgrad verfügt. Dieses soll dadurch erreicht werden, dass man ein Glassubstrat mit einer Rückelektrodenschicht aus Molybdän versieht, deren Dicke 500 nm nicht überschreiten soll.

Die WO2005088731 offenbart einen zusammengesetzten Rückkontakt einer auf CIGSbasierenden Dünnschichtsolarzellen. Der zusammengesetzte Rückkontakt ist zwischen dem Substrat und dem Absorber vorgesehen und umfasst: eine hintere Reflektorschicht, die das Reflexionsvermögen an der Absorber / Verbund-Rückkontaktgrenzfläche erhöht; und mindestens eine Kontaktschicht, die geeignete elektrische Eigenschaften des Rückkontakts in Bezug auf den Absorber gewährleistet und eine Leitfähigkeitsschicht, die einen niedrigen Schichtwiderstand für den Stromfluss in der Ebene gewährleistet.

Dass unterschiedlichste Metalle wie Wolfram, Molybdän, Chrom, Tantal, Niob, Vanadium, Titan und Mangan als geeignete Rückelektrodenmaterialen für Dünnschichtsolarzellen in Frage kommen, ist schon bei Orgassa et al. (Thin Solid Films, 2003, Vol. 431-432, Seiten 1987 bis 1993) zu finden.

Demgemäß lag der vorliegenden Erfindung die Aufgabe zugrunde, Rückelektrodensysteme für Dünnschichtsolarzellen bzw. -module zur Verfügung zu stellen, die nicht mehr mit den Nachteilen des Stands der Technik behaftet sind und die insbesondere auf kostengünstige und zuverlässige Weise reproduzierbar zu Dünnschichtsolarmodulen mit hohen Wirkungsgraden führen.

Demgemäß wurde eine Mehrschicht-Rückelektrode für eine photovoltaische Dünnschichtsolarzelle bzw. -modul gefunden, umfassend, in dieser Reihenfolge, mindestens eine Bulk-Rückelektrodenschicht, enthaltend oder aus V, Mn, Cr, Mo, Co, Zr, Ta, Nb und/oder W und/oder enthaltend oder bestehend aus Legierungen enthaltend V, Mn, Cr, Mo, Co, Zr, Fe, Ni, Al, Ta, Nb und/oder W; mindestens eine leitfähige Barriereschicht; mindestens eine, insbesondere Ohm'sche, Kontaktschicht, enthaltend mindestens eine erste Lage, benachbart zur Barriereschicht, aus Mo, W, Ta, Nb, Zr und/oder Co, insbesondere Mo und/oder W, und mindestens eine zweite Lage, nicht benachbart zur Barriereschicht, d.h. jedenfalls durch die erste Lage getrennt von der Barriereschicht, enthaltend oder aus mindestens einem Metallchalkogenid.

Dabei kann in einer bevorzugten Ausgestaltung vorgesehen sein, dass die Bulk-Rückelektrode und die Kontaktschicht Molybdän oder Wolfram oder eine Molybdän- oder Wolframlegierung, insbesondere Molybdän oder eine Molybdänlegierung, enthalten.

Ferner kann vorgesehen sein, dass die Barriereschicht eine Barriere für aus der und/oder über die Bulk-Rückelektrodenschicht migrierende, insbesondere diffundierende bzw. diffundierbare, Komponenten und/oder für aus der und/oder über die Kontaktschicht migrierende, insbesondere diffundierende bzw. diffundierbare, Komponenten darstellt. Die Barriereschicht stellt demgemäß bevorzugt eine bidirektional wirkende Barriere dar. Vorteilhafterweise kann in diesem Zusammenhang auch vorgesehen sein, dass die Barriereschicht eine Barriere für Alkaliionen, insbesondere Natriumionen, Selen oder Selenverbindungen, Schwefel oder Schwefelverbindungen, Metalle, insbesondere Cu, In, Ga, Fe, Ni, Ti, Zr, Hf, V, Nb, Ta, Al und/oder W, und/oder Verbindungen enthaltend Alkaliionen, z.B. Natriumionen, darstellt. In einer besonders zweckmäßigen Ausgestaltung ist vorgesehen, dass die Barriereschicht enthält oder gebildet ist aus mindestens einem Metallnitrid, insbesondere TiN, MoN, TaN, ZrN und/oder WN, mindestens einem Metallcarbid, mindestens einem Metallborid und/oder mindestens einem Metallsiliziumnitrid, insbesondere TiSiN, TaSiN und/oder WSiN. Bevorzugt stellt das Metall der Metallnitride, Metallsiliziumnitride, Metallcarbide und/oder Metallboride Titan, Molybdän, Tantal oder Wolfram dar. Derartige Metallnitride sind bevorzugt als Barrierematerialien im Sinne der vorliegenden Erfindung, beispielsweise TiN, bei denen das Metall hinsichtlich Stickstoff stöchiometrisch oder überstöchiometrisch, also mit Stickstoff im Überschuss, abgeschieden wird.

Die leitfähige Barriereschicht stellt als bidirektional wirkende Barriereschicht eine Barriere für aus der und/oder über die Rückelektrodenschicht migrierende, insbesondere diffundierende bzw. diffundierbare Komponente, insbesondere Dotierstoffe, und für aus der und/oder über die Kontaktschicht, insbesondere aus der Halbleiterabsorberschicht, diffundierende bzw. diffundierbare Komponente, insbesondere Dotierstoffe, dar. Bedingt durch den Umstand des Vorliegens einer Barriereschicht ist es z.B. möglich, den Reinheitsgrad des Bulk-Rückelektrodenmaterials signifikant zu reduzieren. Beispielsweise kann die Bulk-Rückelektrodenschicht verunreinigt sein mit mindestens einem Element ausgewählt aus der Gruppe bestehend aus Fe, Ni, Ti, Zr, Hf, V, Nb, Ta, Al, W und/oder Na und/oder mit Verbindungen der genannten Elemente, ohne dass der Wirkungsgrad der die erfindungsgemäße Rückelektrode aufweisenden Dünnschichtsolarzelle bzw. des - moduls nachhaltig beeinträchtigt wird.

Ein weiterer Vorteil des Einsatzes einer Barriereschicht mit der erfindungsgemäßen Mehrschicht-Rückelektroden manifestiert sich bei Verwendung in Dünnschichtsolarzellen und - modulen darin, dass die Dicke der Halbleiterabsorberschicht, beispielsweise der Chalkopyrit- oder Kesterit- Schicht, gegenüber herkömmlichen System merklich verringert werden kann. Denn durch die Barriereschicht, insbesondere wenn in Form von Metallnitriden, beispielsweise Titannitrid, oder enthaltend solche Metall- bzw. Titannitride vorliegend, wird das die Halbleiterabsorberschicht passierende Sonnenlicht sehr effektiv reflektiert, so dass sich im Wege des Doppeldurchtritts durch die Halbleiterabsorberschicht eine sehr gute Quantenausbeute erzielen lässt. Durch die Anwesenheit der genannten Barriereschicht in der erfindungsgemäßen Rückelektrode bzw. in Dünnschichtsolarzellen bzw. -modulen, enthaltend diese Rückelektrode kann die durchschnittliche Dicke der Halbleiterabsorberschicht auf z. B. Werte im Bereich von 0,4 µm bis 1,5 µm, beispielsweise auf Werte im Bereich von 0,5 µm bis 1,2 µm, verringert werden.

Die Barriereschicht der erfindungsgemäßen Rückelektrode verfügt in einer besonders zweckmäßigen Ausgestaltung über Barriereeigenschaften, insbesondere bidirektionale Barriereeigenschaften, gegenüber Dotierstoffen, insbesondere gegenüber Dotierstoffen für die Halbleiterabsorberschicht und/oder aus der Halbleiterabsorberschicht, gegenüber Chalkogenen wie Selen und/oder Schwefel sowie Chalkogenverbindungen, gegenüber den metallischen Bestandteilen der Halbleiterabsorberschicht wie Cu, In, Ga, Sn und/oder Zn, gegenüber Verunreinigungen wie Eisen und/oder Nickel aus der Bulk-Rückelektrodenschicht und/oder gegenüber Komponenten und/oder Verunreinigungen aus dem Substrat. Die bidirektionalen Barriereeigenschaften gegenüber Dotierstoffen aus dem Substrat sollen zum einen eine Anreicherung an der Grenzfläche der Rückelektrode bzw. Kontaktschicht zur Halbleiterabsorberschicht mit Alkaliionen, z.B. ausdiffundierend aus einem Glassubstrat, verhindern. Solche Anreicherungen sind bekannt als Grund für Halbleiter-Schichtablösungen. Die leitfähige Barrierenschicht soll damit Haftungsprobleme vermeiden helfen. Andererseits soll die Barriereeigenschaft für Dotierstoffe, ausdiffundierbar bzw. ausdiffundierend aus dem Halbleiterabsorber, verhindern, dass Dotierstoff auf diese Weise an die Bulk-Rückelektrode verlorengeht und damit der Halbleiterabsorber an Dotierstoff verarmt, was den Wirkungsgrad der Solarzelle oder des Solarmoduls deutlich reduzieren würde. Denn es ist beispielsweise bekannt, dass Molybdän-Rückelektroden signifikante Mengen an Natrium-Dotierstoff aufnehmen können. Die bidirektionale leitfähige Barriereschicht soll somit die Voraussetzungen für eine gezielte Dosierung von Dotierstoff in die Halbleiterabsorberschicht ermöglichen, um reproduzierbar hohe Wirkungsgrade der Solarzellen und -Modulen erreichen zu können.

Die Barriereeigenschaft gegenüber Chalkogenen soll verhindern, dass diese an die Rückelektrode gelangen und dort Metallchalkogenidverbindungen ausbilden. Bekanntlich tragen diese Chalkogenidverbindungen, z.B. MoSe, zu einer erheblichen Volumenvergrößerung der oberflächennahen Schicht der Rückelektrode bei, was wiederum Unebenheiten in der Schichtenstruktur und verschlechterte Haftung mit sich bringt. Verunreinigungen des Bulk-Rückelektrodenmaterials wie Fe und Ni stellen sogenannte tiefe Störstellen für Chalkopyrit-Halbleiter (Halbleitergifte) dar und sind demzufolge über die Barriereschicht von der Halbleiterabsorberschicht fernzuhalten.

Des Weiteren kann in einer Ausführungsform vorgesehen sein, dass das Metall des Metallchalkogenids der Kontaktschicht bzw. der zweiten Lage der Kontaktschicht ausgewählt ist aus Molybdän, Wolfram, Tantal, Zirkonium, Cobalt und/oder Niob und dass das Chalkogen des Metallchalkogenids ausgewählt ist aus Selen und/oder Schwefel, wobei das Metallchalkogenid insbesondere MSe₂, MS₂ und/oder M(Se₁₋ₓ,Sₓ)₂ darstellt mit M = Mo, W, Ta, Zr, Co oder Nb, wobei x beliebige Werte von 0 bis 1 annimmt. Bevorzugt werden Metallchalkogenide ausgewählt aus der Gruppe MoSe₂, WSe₂, TaSe₂, NbSe₂, Mo(Se₁₋ₓ,Sₓ)₂, W(Se₁₋ₓ,Sₓ)₂, Ta(Se₁₋ₓ,Sₓ)₂ und/oder Nb(Seᵢ₁₋ₓ,Sₓ)₂, wobei x beliebige Werte von 0 bis 1 annimmt.

Ferner ist bevorzugt, dass das Metall der ersten Lage und das Metall der zweiten Lage der Kontaktschicht übereinstimmen und/oder dass das Metall der ersten Lage und/oder das Metall der zweiten Lage der Kontaktschicht mit dem Metall der Bulk-Rückelektrode übereinstimmen.

Von besonderen Vorteilen sind auch solche erfindungsgemäße Rückelektroden, bei denen die Kontaktschicht, die erste und/oder die zweite Lage der Kontaktschicht mindestens einen Dotierstoff für eine Halbleiterabsorberschicht einer Dünnschichtsolarzelle, insbesondere mindestens ein Element ausgewählt aus der Gruppe Natrium, Kalium und Lithium und/oder mindestens eine Verbindung dieser Elemente, vorzugsweise mit Sauerstoff, Selen, Schwefel, Bor und/oder Halogenen, z.B. Jod oder Fluor, und/oder mindestens eine Alkalimetallbronze, insbesondere Natrium- und/oder Kaliumbronze, vorzugsweise mit einem Metall ausgewählt aus Molybdän, Wolfram, Tantal und/oder Niob, aufweisen. Geeignete Bronzen umfassen Mischoxide oder Mischungen aus Mischoxiden und Oxiden, beispielsweise Na₂MoO₂ + WO. Die dotierte Kontaktschicht ist zum Beispiel erhältlich durch Auftragen des mit dem Dotierstoff in der Metallchalkogenidquelle versetzten Metallchalkogenid.

Im Sinne der Erfindung ist vorzugsweise vorgesehen, dass die durchschnittliche Dicke der Bulk-Rückelektrodenschicht im Bereich von 50 nm bis 500 nm, insbesondere im Bereich von 80 nm bis 250 nm, und/oder die durchschnittliche Dicke der Barriereschicht im Bereich von 10 nm bis 250 nm, insbesondere im Bereich von 20 nm bis 150 nm, und/oder die durchschnittliche Dicke der Kontaktschicht im Bereich von 2 nm bis 200 nm, insbesondere im Bereich von 5 nm bis 100 nm, liegen. Dabei ist die Gesamtdicke der Mehrschicht-Rückelektrode vorzugsweise so einzustellen, dass der spezifische Gesamtwiderstand der erfindungsgemäßen Rückelektrode 50 microOhm*cm, bevorzugt 10 microOhm*cm, nicht überschreitet. Unter diesen Vorgaben lassen sich Ohm'sche Verluste in einem serienverschalteten Modul nochmals zu reduzieren.

In einer besonders zweckmäßigen Ausgestaltung ist vorgesehen, dass die Bulk-Rückelektrodenschicht Molydän und/oder Wolfram, insbesondere Molybdän, enthält oder im Wesentlichen aus Molydän und/oder Wolfram, insbesondere Molybdän, gebildet ist, die leitfähige Barriereschicht TiN enthält oder im Wesentlichen aus TiN gebildet ist, und die, insbesondere Dotierstoff(e) enthaltende, Kontaktschicht MoSe₂ enthält oder im Wesentlichen aus MoSe₂ gebildet ist.

Es hat sich als zweckmäßig erwiesen, wenn der Dotierstoff, insbesondere Natriumionen, in der Kontaktschicht und/oder in der Halbleiterabsorberschicht der die Rückelektrode aufweisenden Dünnschichtsolarzelle bzw. -modul in einer Dosis im Bereich von 10¹³ bis 10¹⁷ Atomen/cm², bevorzugt in einer Dosis im Bereich von 10¹⁴ bis 10¹⁶ Atomen/cm² vorliegt.

Für den Fall der Dotierung der Kontaktschicht mit Dotierstoffen für die Halbleiterabsorberschicht einer Dünnschichtsolarzelle hat sich die erfindungsgemäße Mehrschicht-Rückelektrode bewährt. Bei der Herstellung der Halbleiterabsorberschicht werden regelmäßig Temperaturen oberhalb von 300 bzw. oberhalb von 350°C eingesetzt. Häufig liegen diese Temperaturen auch im Bereich von 500°C bis 600°C. Bei derartigen Temperaturen migrieren, insbesondere diffundieren, Dotierstoffe, wie insbesondere Natriumionen bzw. Natriumverbindungen, aus der dotierten Kontaktschicht in die Halbleiterabsorberschicht. Bedingt durch die Barriereschicht findet eine Migration bzw. Diffusion in die Rückelektrodenschicht nicht statt.

Aufgrund der genannten relativ hohen Temperaturen bei der Prozessierung des Halbleiters ist es vorteilhaft, dass die ausgewählten Schichten der Mehrschichtrückelektrode, insbesondere die Bulk-Rückelektrode und/oder die leitfähige Barrierenschicht so zusammengesetzt sind, dass deren linearer thermischer Ausdehnungskoeffizient an den des Halbleiterabsorbers und/oder des Substrates angepasst sind. Daher sollten insbesondere die Bulk-Rückelektrode und/oder die Barriereschicht der erfindungsgemäßen Dünnschichtsolarzellen und -module vorzugsweise so zusammengesetzt sein, dass ein linearer thermischer Ausdehnungskoeffizient von 14*10⁻⁶⁻K, bevorzuget von 9*10⁻⁶⁻K nicht überschritten wird.

Die der Erfindung zugrunde liegende Aufgabe wird ebenfalls gelöst durch photovoltaische Dünnschichtsolarzellen und -module, enthaltend die erfindungsgemäße Mehrschicht-Rückelektrode.

In einer bevorzugten Ausgestaltung verfügt die erfindungsgemäße Dünnschichtsolarzelle, in dieser Reiheinfolge, über mindestens eine Substratschicht, mindestens eine erfindungsgemäße Rückelektrodenschicht, mindestens eine leitfähige Barriereschicht, mindestens eine, insbesondere an der Kontaktschicht unmittelbar anliegende, Halbleiterabsorberschicht, insbesondere eine Chalkopyrit- oder Kesterit-Halbleiterabsorberschicht, und mindestens eine Frontelektrode.

Hierbei sind solche Dünnschichtsolarzellen bzw. -module von Vorteil, bei denen zwischen der Halbleiterabsorberschicht und der Frontelektrode mindestens eine Pufferschicht (auch erste Pufferschicht genannt), insbesondere mindestens eine Schicht, enthaltend oder im Wesentlichen gebildet aus CdS oder einer CdS-freien Schicht, insbesondere enthaltend oder im Wesentlichen aus Zn(S,OH) oder In₂S₃, und/oder mindestens eine Schicht (auch zweite Pufferschicht genannt), enthaltend und im Wesentlichen gebildet aus intrinsischem Zinkoxid und/oder hochohmigem Zinkoxid, vorliegt.

Als besonders zweckmäßig haben sich auch derartige erfindungsgemäße Dünnschichtsolarzellen erwiesen, bei denen die Halbleiterabsorberschicht eine quaternäre IB-IIIA-VIA-Chalkopyritschicht, insbesondere eine Cu(In,Ga)Se₂-Schicht, eine penternäre IB-IIIA-VIA-Chalkopyritschicht, insbesondere eine Cu(In,Ga)(Se₁₋ₓ,Sₓ)₂-Schicht, oder eine Kesterit-Schicht, insbesondere eine Cu₂ZnSn(Seₓ,S₁₋ₓ)₄-Schicht, wobei x beliebige Werte von 0 bis 1 annimmt, darstellt oder umfasst. Den Kesterit-Schichten liegt in der Regel eine IB-IIA-IVA-VIA-Struktur zugrunde. Exemplarisch seien Cu₂ZnSnSe₄ und Cu₂ZnSnS₄ genannt.

Die durchschnittliche Dicke der Halbleiterabsorberschicht liegt üblicher Weise im Bereich von 400 nm bis 2500 nm, insbesondere im Bereich von 500 nm bis 1500 nm und vorzugsweise im Bereich von 800 nm bis 1200 nm.

Erfindungsgemäße photovoltaische Dünnschichtsolarmodule umfassen mindestens zwei, insbesondere eine Vielzahl an, insbesondere monolithisch integriert serienverschalteten, erfindungsgemäßen Dünnschichtsolarzellen. Beispielsweise können in einem erfindungsgemäßen Dünnschichtsolarmodul 20 bis 150 oder 50 bis 100 serienverschaltete erfindungsgemäße Dünnschichtsolarzellen vorliegen.

Der spezifische Gesamtwiderstand der erfindungsgemäßen Mehrschicht-Rückelektrode sollte in einer geeigneten Ausgestaltung nicht über 50 microOhm*cm liegen, bevorzugt nicht über 10 microOhm*cm. Auf diese Weise soll eine möglichst verlustarme, monolithisch integrierte Serienverschaltung sichergestellt werden können.

Die der Erfindung zugrunde liegende Aufgabe wird des weiteren gelöst durch ein Verfahren zur Herstellung einer erfindungsgemäßen photovoltaischen Dünnschichtsolarzelle oder eines erfindungsgemäßen photovoltaischen Dünnschichtsolarmoduls, umfassend die Schritte:
Applizieren der Bulk-Rückelektrodenschicht, der Barrierenschicht, der Kontaktschicht, der Metalle der Halbleiterabsorberschicht und/oder des/der Dotierstoffe mittels physikalischer Dünnschicht-Abscheideverfahren, insbesondere umfassend Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron-Sputtern, jeweils vorzugsweise in einem Hochvakuum, oder mittels chemischer Gasphasenabscheidung, insbesondere umfassend Chemical Vapour Deposition (CVD), Niedrigdruck- (low pressure) CVD und/oder Atmosphären- (atmospheric pressure).

Hierbei ist eine solche Ausführung von Vorteil, bei der die Bulk-Rückelektrodenschicht, die Barrierenschicht, die Kontaktschicht, die Metalle der Halbleiterabsorberschicht und/oder der/die Dotierstoffe mittels Kathodenzerstäubung (Sputter-Beschichtung), insbesondere DC-Magnetron-Sputterns, appliziert werden.

Dabei kann ferner vorgesehen, dass der/die Dotierstoffe zusammen mit mindestens einer Komponente der Kontaktschicht und/oder der Absorberschicht, insbesondere aus einem gemeinsamen Misch- oder Sintertarget, appliziert werden. Schließlich hat es sich auch als zweckmäßig erwiesen, dass das Misch- oder Sintertarget mindestens einen Dotierstoff, ausgewählt aus einer Natriumverbindung, einer Natrium-Molybdän-Bronze und einer Natrium-Wolfram-Bronze, insbesondere in einer Matrix-Komponente, ausgewählt aus MoSe₂, WSe₂, Mo, W, Kupfer und/oder Gallium enthält. Beispielsweise kann ein Molybdänselenid-Target mit Natriumsulfit oder Natriumsulfid als Dotierstoff versetzt sein.

Mit der vorliegenden Erfindung geht die überraschende Erkenntnis einher, dass sich mit Aufbau der erfindungsgemäßen Mehrschicht-Rückelektrode relativ dünne Schichtdicken der Halbleiterabsorberschicht in Dünnschichtsolarzellen bzw. -modulen realisieren lassen, ohne Wirkungsgradverluste in Kauf nehmen zu müssen. Mit den erfindungsgemäßen Systemen stellen sich häufig sogar höhere Wirkungsgrade ein. Diesbezüglich wurde gefunden, dass die das Sonnenlicht reflektierenden Barriereschichten zu einer weiteren Stromgenerierung beitragen. Das Sonnenlicht passiert hier die Halbleiterabsorberschicht zweimal. Überraschend wurde ferner gefunden, dass eine verbesserte Wirkung auch damit einhergeht, dass die Halbleiterabsorberschicht, z.B. auf Basis eines Chalkopyrit- oder Kesterit-Systems, unmittelbar auf einer Molybdän-Kontaktschicht abgeschieden wird. Diese kann hierbei im sich anschließenden Halbleiter-Bildungsprozess an der Grenzfläche zu Molybdänselenid oder -sulfoselenid reagieren. Ferner wurde überraschend gefunden, dass sich Dotierstoffe für die Halbleiterabsorberschicht, beispielsweise auf Basis von Natrium, wohl dosiert über die Kontaktschicht, d.h. ursprünglich in der Kontaktschicht vorliegend, in die genannte Halbleiterabsorberschicht einbringen. Hierfür reichen schon die Temperaturen bei der Bildung der Halbleiterabsorberschicht aus, wobei unterstützend die Barriereschicht die Wanderungsrichtung der Dotierstoffe in Richtung der Halbleiterabsorberschicht mit beeinflusst. Die genannten Dotierstoffe, sobald in der Halbleiterabsorberschicht vorliegend, tragen regelmäßig zur Erhöhung des Wirkungsgrads einer Dünnschichtsolarzelle bzw. eines -moduls bei. Hierbei hat sich als vorteilhaft herausgestellt, dass sich über den Eintrag über die Kontaktschicht die Menge an Dotierstoff, die letztendlich im fertig gestellten Produkt in der Halbleiterabsorberschicht vorliegt, sehr genau einstellen lässt. Erst auf diese Weise gelingt eine reproduzierbare Erhöhung des Wirkungsgrades unabhängig von der Zusammensetzung des Glases und/oder der Bulk-Rückelektrode. Mit den erfindungsgemäßen Systemen lassen sich überraschender Weise auch Wirkungsgradverluste durch unkontrollierte Reaktionen des Chalkogens, insbesondere Selens, während der Bildung der Halbleiterabsorberschicht mit der Bulk-Rückelektrode vermeiden. Indem es auf der Oberfläche der Bulk-Rückelektrode nicht mehr zu einer Bildung von Metallchalkogeniden, wie Molybdänselenid, kommt, wird auch ein Verlust an Leitfähigkeit der Bulk-Rückelektrode sowie eine lateral inhomogene Chalkogenidbildung vermieden und damit die Bildung von Mikrorissen unterbunden.

Denn mit der Chalkonidbildung geht regelmäßig eine beträchtliche Volumenexpansion einher. Mit den erfindungsgemäßen Systemen ist es z.B. möglich, die Dicke der einzelnen Schichten wie auch die Dicke des Gesamtsystems genauer und zuverlässiger einzustellen als bei herkömmlichen Dünnschichtsystemen. Gleichzeitig erlauben die erfindungsgemäßen Mehrschicht-Rückelektroden die Verwendung von verunreinigtem Bulk-Rückelektrodenmaterial, ohne dass der Wirkungsgrad der Dünnschichtsolarzelle nachteilig beeinflusst wird. Hiermit lassen sich die Gesamtkosten eines Dünnschichtsolarmoduls merklich reduzieren. Ferner findet mit den erfindungsgemäßen Mehrschicht- Rückelektroden ein wesentlich kontrallierterer Aufbau der Halbleiterabsorberschicht statt. Bestandteile des Halbleiters wie Cu, In und/oder Ga wandern nicht mehr in die Rückelektrode ab, wodurch das gewünschte Massenverhältnis der die Halbleiterabsorberschicht bildenden Komponenten gezielter eingestellt und auch gehalten werden kann.

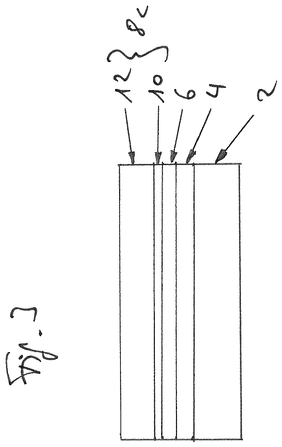

Weitere Merkmale und Vorteile der Erfindung ergeben sich aus der nachgehenden Beschreibung, in der eine bevorzugte Ausführungsform der Erfindung beispielhaft anhand der Figur 3 erläutert ist. Dabei zeigen:
- Figur 1: eine schematische Querschnittsansicht durch ein Teilsystem einer Dünnschichtsolarzelle, enthaltend eine Mehrschicht-Rückelektrode;
- Figur 2: eine schematische Querschnittsansicht durch ein Teilsystem einer Dünnschichtsolarzelle, enthaltend eine Mehrschicht-Rückelektrode; und
- Figur 3: eine schematische Querschnittsansicht durch ein Teilsystem einer DünnschichtsolarzelLe, enthaltend eine Ausführungsform einer erfindungsgemäßen Mehrschicht-Rückelektrode.

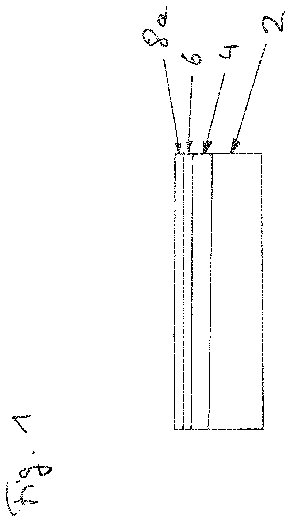

Auf der Substratschicht 2, beispielsweise einem Glassubstrat, liegt in der in Figur 1 abgebildeten Mehrschicht-Rückelektrode 1 eine Bulk-Rückelektrodenschicht 4 aus Molybdän vor. Hierauf aufliegend befindet sich eine bidirektional wirkende leitfähige Barriereschicht 6 aus zum Beispiel Wolframnitrid oder Titannitrid, und an diese Schicht angrenzend die Ohm'sche Kontaktschicht 8a aus einem Metallchalkogenid wie Molybdänselenid. Die Kontaktschicht 8a kann dabei auch mit mindestens einem Dotierstoff versetzt sein, beispielsweise Natriumionen oder einer Natriumverbindung, insbesondere Natriumsulfit oder Natriumsulfid.

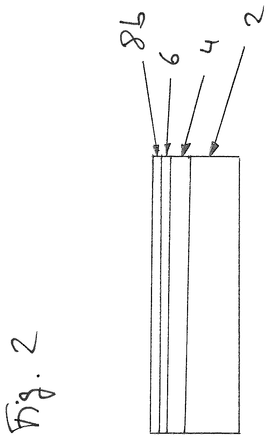

In der in Figur 2 wiedergegebenen Mehrschicht-Elektrode 1 stellt die Kontaktschicht 8b abweichend zu der Figur 1 eine Metallschicht, beispielsweise eine Molybdän- oder Wolframschicht dar. Auch diese Kontaktschicht 8b kann mit mindestens einem Dotierstoff versetzt sein, beispielsweise Natriumionen oder einer Natriumverbindung, insbesondere Natriumsulfit oder Natriumsulfid.

In der in Figur 3 wiedergegebenen Ausführungsform einer erfindungsgemäßen Mehrschicht-Elektrode 1 stellt die Kontaktschicht 8c ein Zweischichtsystem aus einer ersten Lage 10 aus einem Metall, beispielsweise Molybdän oder Wolfram, welche an die Barriereschicht 6 angrenzt bzw. zu dieser benachbart ist, und einer zweiten Lage 12 aus einem Metallchalkogenid, beispielsweise Molybdänselenid und/oder Wolframselenid, das an die erste Lage 10 angrenzt und damit nicht benachbart ist zur Barriereschicht 6, dar.

Auch bei dieser Ausführungsform liegt in der Kontaktschicht 8c bevorzugt mindestens ein Dotierstoff vor, beispielsweise Natriumionen oder einer Natriumverbindung, insbesondere Natriumsulfit oder Natriumsulfid. Hierbei kann der Dotierstoff in der ersten und/oder der zweiten Lage zugegen sein.

Die in der vorstehenden Beschreibung, in den Ansprüchen sowie in den Zeichnungen offenbarten Merkmale der Erfindung können sowohl einzeln aus auch in jeder beliebigen Kombination für die Verwirklichung der Erfindung in ihren verschiedenen Ausführungsformen wesentlich sein.

## Patentansprüche

1. Mehrschicht-Rückelektrode (1) für eine photovoltaische Dünnschichtsolarzelle, umfassend, in dieser Reihenfolge,
mindestens eine Bulk-Rückelektrodenschicht (4), enthaltend oder aus V, Mn, Cr, Mo, Co, Zr, Ta, Nb und/oder W und/oder enthaltend oder bestehend aus Legierungen enthaltend V, Mn, Cr, Mo, Co, Zr, Fe, Ni, Al, Ta, Nb und/oder W, mindestens eine leitfähige Barriereschicht (6),
mindestens eine, insbesondere Ohm'sche, Kontaktschicht (8c),
enthaltend mindestens eine erste Lage (10), benachbart zur Barriereschicht (6), aus Mo, W, Ta, Nb, Zr und/oder Co, insbesondere Mo und/oder W, und mindestens eine zweite Lage (12), nicht benachbart zur Barriereschicht (6), enthaltend oder aus mindestens einem Metallchalkogenid.

2. Mehrschicht-Rückelektrode (1) nach Anspruch 1, **dadurch gekennzeichnet, dass** die Bulk-Rückelektrode und die Kontaktschicht (8c) Molybdän oder Wolfram oder eine Molybdän- oder eine Wolframlegierung enthalten.

3. Mehrschicht-Rückelektrode (1) nach Anspruch 1 oder 2, **dadurch gekennzeichnet, dass** die Barriereschicht (6) eine Barriere für aus der und/oder über die Bulk-Rückelektrodenschicht (4) migrierende, insbesondere diffundierende bzw. diffundierbare Komponenten und/oder für aus der und/oder über die Kontaktschicht (8c) migrierende, insbesondere diffundierende bzw. diffundierbare Komponenten darstellt.

4. Mehrschicht-Rückelektrode (1) nach einem der vorangehenden Ansprüche, **dadurch gekennzeichnet, dass** die Barriereschicht (6) eine Barriere für Alkaliionen, insbesondere Natriumionen, Selen oder Selenverbindungen, Schwefel oder Schwefelverbindungen, Metalle, insbesondere Cu, In, Ga, Fe, Ni, Ti, Zr, Hf, V, Nb, Ta, Al und/oder W, und/oder Verbindungen enthaltend Alkaliionen darstellt.

5. Mehrschicht-Rückelektrode (1) nach einem der vorangehenden Ansprüche, **dadurch gekennzeichnet, dass** die Barriereschicht (6) enthält oder gebildet ist aus mindestens einem Metallnitrid, insbesondere TiN, MoN, TaN, ZrN und/oder WN, mindestens einem Metallcarbid, mindestens einem Metallborid und/oder mindestens einem Metallsiliziumnitrid, insbesondere TiSiN, TaSiN und/oder WSiN.

6. Mehrschicht-Rückelektrode (1) nach einem der vorangehenden Ansprüche, **dadurch gekennzeichnet, dass** die Bulk-Rückelektrodenschicht (4) verunreinigt ist mit mindestens einem Element ausgewählt aus der Gruppe bestehend aus Fe, Ni, Ti, Zr, Hf, V, Nb, Ta, W, Al und/oder Na und/oder mit Verbindungen der genannten Elemente.

7. Mehrschicht-Rückelektrode (1) nach einem der vorangehenden Ansprüche, **dadurch gekennzeichnet, dass** das Metall des Metallchalkogenids der Kontaktschicht (8c) bzw. der zweiten Lage (12) der Kontaktschicht (8c) ausgewählt ist aus Molybdän, Wolfram, Tantal, Zirkonium, Cobalt und/oder Niob und dass das Chalkogen des Metallchalkogenids ausgewählt ist aus Selen und/oder Schwefel, wobei das Metallchalkogenid insbesondere MSe₂, MS₂ und/oder M(Se₁₋ₓ, Sₓ)₂ darstellt mit M = Mo, W, Ta, Zr, Co oder Nb, wobei x Werte von o bis 1 annimmt.

8. Mehrschicht-Rückelektrode (1) nach einem der vorangehenden Ansprüche, **dadurch gekennzeichnet, dass** das Metall der ersten Lage (10) und das Metall der zweiten Lage (12) der Kontaktschicht (8c) übereinstimmen und/oder dass das Metall der ersten Lage (10) und/oder das Metall der zweiten Lage (12) der Kontaktschicht (8c) mit dem Metall der Bulk-Rückelektrode übereinstimmen.

9. Mehrschicht-Rückelektrode (1) nach einem der vorangehenden Ansprüche, **dadurch gekennzeichnet, dass** die Kontaktschicht (8c), die erste und/oder die zweite Lage (10, 12) der Kontaktschicht (8c) mindestens einen Dotierstoff für eine Halbleiterabsorberschicht einer Dünnschichtsolarzelle, insbesondere mindestens ein Element ausgewählt aus der Gruppe Natrium, Kalium und Lithium und/oder mindestens eine Verbindung dieser Elemente, vorzugsweise mit Sauerstoff, Selen, Schwefel, Bor und/oder Halogenen, z.B. Jod, oder Fluor, und/oder mindestens eine Alkalimetallbronze, insbesondere Natrium- und/oder Kaliumbronze, vorzugsweise mit einem Metall ausgewählt aus Molybdän, Wolfram, Tantal und/oder Niob, aufweist.

10. Mehrschicht-Rückelektrode (1) nach einem der vorangehenden Ansprüche, **dadurch gekennzeichnet, dass** die durchschnittliche Dicke der Bulk-Rückelektrodenschicht (4) im Bereich von 50 nm bis 500 nm, insbesondere im Bereich von 80 nm bis 250 nm, und/oder die der Barriereschicht (6) im Bereich von 10 nm bis 250 nm, insbesondere im Bereich von 20 nm bis 150 nm, und/oder die der Kontaktschicht (8c) im Bereich von 2 nm bis 200 nm, insbesondere im Bereich von 5 nm bis 100 nm, liegt.

11. Mehrschicht-Rückelektrode (1) nach einem der vorangehenden Ansprüche, **dadurch gekennzeichnet, dass**
die Bulk-Rückelektrodenschicht (4) Molydän und/oder Wolfram, insbesondere Molybdän, enthält oder im Wesentlichen aus Molydän und/oder Wolfram, insbesondere Molybdän, gebildet ist,
die leitfähige Barriereschicht (6) TiN enthält oder im Wesentlichen aus TiN gebildet ist, und
die, insbesondere Dotierstoff(e) enthaltende, Kontaktschicht MoSe2 enthält oder im Wesentlichen aus MoSe2 gebildet ist.

12. Mehrschicht-Rückelektrode (1) nach einem der Ansprüche 9 bis 11, **dadurch gekennzeichnet, dass** der Dotierstoff, insbesondere Natriumionen, in der Kontaktschicht (8c) in einer Dosis im Bereich von 10¹³ bis 10¹⁷ Atomen/cm² insbesondere im Bereich von 10¹⁴ bis 10¹⁶ Atomen/cm² vorliegt.

13. Photovoltaische Dünnschichtsolarzelle, umfassend mindestens eine Mehrschicht-Rückelektrode (1) gemäß einem der vorangehenden Ansprüche.

14. Dünnschichtsolarzelle nach Anspruch 13, umfassend, in dieser Reihenfolge, mindestens eine Substratschicht (2), mindestens eine Rückelektrodenschicht gemäß einem der Ansprüche 1 bis 12, mindestens eine leitfähige Barriereschicht (6), mindestens eine, insbesondere an der Kontaktschicht (8c) unmittelbar anliegende, Halbleiterabsorberschicht, insbesondere Chalkopyrit- oder Kesterit-Halbleiterabsorberschicht, und mindestens eine Frontelektrode.

15. Dünnschichtsolarzelle nach Anspruch 14, **dadurch gekennzeichnet, dass** zwischen der Halbleiterabsorberschicht und der Frontelektrode mindestens eine Pufferschicht, insbesondere mindestens eine Schicht, enthaltend oder im Wesentlichen gebildet aus CdS oder einer CdS-freien Schicht, insbesondere enthaltend oder im Wesentlichen aus Zn(S, OH) oder In₂S₃, und/oder mindestens eine Schicht, enthaltend und im Wesentlichen gebildet aus intrinsischem Zinkoxid und/oder hochohmigem Zinkoxid, vorliegt.

16. Dünnschichtsolarzelle nach einem der Ansprüche 13 bis 15, **dadurch gekennzeichnet, dass** die Halbleiterabsorberschicht eine quaternäre IB-IIIA-VIA-Chalkopyritschicht, insbesondere eine Cu(In, Ga)Se2-Schicht, eine penternäre IB-IIIA-VIA-Chalkopyritschicht, insbesondere eine Cu(In, Ga)(Se₁₋ₓ, Sₓ)₂-Schicht, oder eine Kesterit-Schicht, insbesondere eine Cu₂ZnSn(Seₓ, S₁₋ₓ)₄-Schicht, wobei x Werte von o bis 1 annimmt, darstellt oder umfasst und/oder dass die durchschnittliche Dicke der Halbleiterabsorberschicht im Bereich von 400 nm bis 2500 nm, insbesondere im Bereich von 500 nm bis 1500 nm und vorzugsweise im Bereich von 800 nm bis 1200 nm, liegt.

17. Photovoltaisches Dünnschichtsolarmodul, enthaltend mindestens zwei, insbesondere eine Vielzahl an, insbesondere monolithisch integrierten serienverschalteten, Dünnschichtsolarzellen nach einem der Ansprüche 13 bis 16.

18. Verwendung der Mehrschicht-Rückelektrode gemäß einem der Ansprüche 1 bis 12 für die Herstellung von Dünnschichtsolarzellen oder von Dünnschichtsolarmodulen.

19. Verwendung gemäß Anspruch 18 der Mehrschicht-Rückelektrode nach einem der Ansprüche 9 bis 12 für die Dotierung einer Halbleiterabsorberschicht mit einem Dotierstoff, insbesondere ausgewählt aus einer Natriumverbindung, Natriumionen, einer Natrium-Molybdän-Bronze und/oder einer Natrium-Wolfram-Bronze, während der Herstellung einer photovoltaischen Dünnschichtsolarzelle, insbesondere gemäß einem der Ansprüche 13 bis 16, oder eines photovoltaischen Dünnschichtmoduls, insbesondere gemäß Anspruch 17.

20. Verfahren zur Herstellung einer photovoltaischen Dünnschichtsolarzelle gemäß einem der Ansprüche 13 bis 16 oder eines photovoltaischen Dünnschichtsolarmoduls gemäß Anspruch 17, umfassend die Schritte: Applizieren der Bulk-Rückelektrodenschicht (4), der Barrierenschicht, der Kontaktschicht (8c), der Metalle der Halbleiterabsorberschicht und/oder eines Dotierstoffes/von Dotierstoffen mittels physikalischer Dünnschicht-Abscheideverfahren, insbesondere umfassend Physical Vapor Deposition(PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron-Sputtern, jeweils vorzugsweise in einem Hochvakuum, oder mittels chemischer Gasphasenabscheidung, insbesondere umfassend Chemical Vapour Deposition (CVD), Niedrigdruck-(low pressure) CVD und/oder Atmosphären-(atmospheric pressure).

21. Verfahren nach Anspruch 20, **dadurch gekennzeichnet, dass** der Dotierstoff/die Dotierstoffe, insbesondere ausgewählt aus einer Natriumverbindung, Natriumionen, einer Natrium-Molybdän-Bronze und/oder einer Natrium-Wolfram-Bronze, zusammen mit mindestens einer Komponente der Kontaktschicht (8c) und/oder der Absorberschicht, insbesondere aus einem gemeinsamen Misch- oder Sintertarget, appliziert werden.

## Claims

1. A Multi-layer back electrode (1) for a photovoltaic thin-film solar cell, comprising, in this order,
at least one bulk back electrode layer (4) containing or made of V, Mn, Cr, Mo, Co, Zr, Ta, Nb and/or W, and/or containing or consisting of alloys containing V, Mn, Cr, Mo, Co, Zr, Fe, Ni, Al, Ta, Nb and/or W,
at least one conductive barrier layer (6),
at least one contact layer (8c), in particular an ohmic contact layer,
containing at least one first layer (10), adjacent to the barrier layer (6), made of Mo, W, Ta, Nb, Zr and/or Co, in particular Mo and/or W, and at least one second layer (12), not adjacent to the barrier layer (6), containing or made of at least one metal chalcogenide.

2. The multi-layer back electrode (1) according to Claim 1, **characterised in that** the bulk back electrode and the contact layer (8c) contain molybdenum or tungsten or a molybdenum alloy or a tungsten alloy.

3. The multi-layer back electrode (1) according to Claim 1 or 2, **characterised in that** the barrier layer (6) is a barrier to components migrating, in particular diffusing or diffusible components, from and/or through the bulk back electrode layer (4) and/or components migrating, in particular diffusing or diffusible components, from and/or through the contact layer (8c).

4. The multi-layer back electrode (1) according to any of the preceding claims, **characterised in that** the barrier layer (6) is a barrier to alkali ions, in particular sodium ions, selenium or selenium compounds, sulphur or sulphur compounds, metals, in particular Cu, In, Ga, Fe, Ni, Ti, Zr, Hf, V, Nb, Ta, Al and/or W and/or compounds containing alkali ions.

5. The multi-layer back electrode (1) according to any of the preceding claims, **characterised in that** the barrier layer (6) contains or is formed from at least one metal nitride, in particular TiN, MoN, TaN, ZrN and/or WN, at least one metal carbide, at least one metal boride and/or at least one metal silicon nitride, in particular TiSiN, TaSiN and/or WSiN.

6. The multi-layer back electrode (1) according to any of the preceding claims, **characterised in that** the bulk back electrode layer (4) is contaminated with at least one element selected from the group consisting of Fe, Ni, Ti, Zr, Hf, V, Nb, Ta, W, Al and/or Na and/or compounds of said elements.

7. The multi-layer back electrode (1) according to any of the preceding claims, **characterised in that** the metal of the metal chalcogenide of the contact layer (8c) or the second layer (12) of the contact layer (8c) is selected from molybdenum, tungsten, tantalum, zirconium, cobalt and/or niobium, and **in that** the chalcogen of the metal chalcogenide is selected from selenium and/or sulphur, wherein the metal chalcogenide is, in particular, MSe₂, MS₂ and/or
M(Se₁₋ₓ,Sₓ)₂, with M = Mo, W, Ta, Zr, Co or Nb, wherein x has values from 0 to 1.

8. The multi-layer back electrode (1) according to any of the preceding claims, **characterised in that** the metal of the first layer (10) and the metal of the second layer (12) of the contact layer (8c) are the same and/or the metal of the first layer (10) and/or the metal of the second layer (12) of the contact layer (8c) are the same as the metal of the bulk back electrode.

9. The multi-layer back electrode (1) according to any of the preceding claims, **characterised in that** the contact layer (8c), the first and/or second layer (10, 12) of the contact layer (8c), has at least one dopant for a semiconductor absorber layer of a thin-film solar cell, in particular at least one element selected from the group consisting of sodium, potassium and lithium and/or at least one compound of these elements, preferably with oxygen, selenium, sulphur, boron and/or halogens, e.g. iodine or fluorine, and/or at least one alkali metal bronze, in particular sodium bronze and/or potassium bronze, preferably with a metal selected from molybdenum, tungsten, tantalum and/or niobium.

10. The multi-layer back electrode (1) according to any of the preceding claims, **characterised in that** the average thickness of the bulk back electrode layer (4) is in the range of 50 nm to 500 nm, in particular in the range of 80 nm to 250 nm and/or that of the barrier layer (6) is in the range of 10 nm to 250 nm, in particular in the range of 20 nm to 150 nm and/or that of the contact layer (8c) is in the range of 2 nm to 200 nm, in particular in the range of 5 nm to 100 nm.

11. The multi-layer back electrode (1) according to any of the preceding claims, **characterised in that** the bulk back electrode layer (4) contains molybdenum and/or tungsten, in particular molybdenum, or is essentially formed of molybdenum and/or tungsten, in particular molybdenum,
the conductive barrier layer (6) contains TiN or is essentially formed of TiN, and
the contact layer, in particular containing dopant(s), contains MoSe₂ or is essentially formed of MoSe₂.

12. The multi-layer back electrode (1) according to any of Claims 9 to 11, **characterised in that** the amount of dopant, in particular sodium ions, present in the contact layer (8c) is in the range of 10¹³ to 10¹⁷ atoms per cm², and in particular in the range of 10¹⁴ to 10¹⁶ atoms per cm².

13. A photovoltaic thin-film solar cell, comprising at least one multi-layer back electrode (1) according to any of the preceding claims.

14. The thin-film solar cell according to Claim 13 comprising, in this order:
at least one substrate layer (2), at least one back electrode layer according to any of Claims 1 to 12, at least one conductive barrier layer (6), at least one semiconductor absorber layer, in particular directly next to the contact layer (8c), in particular chalcopyrite or kesterite semiconductor absorber layer, and at least one front electrode.

15. The thin-film solar cell according to Claim 14, **characterised in that** between the semiconductor absorber layer and the front electrode at least one buffer layer is present, in particular at least one layer containing or essentially formed of CdS or a CdS-free layer, in particular containing or essentially formed of Zn(S,OH) or In₂S₃, and/or at least one layer containing and essentially formed of intrinsic zinc oxide and/or high-resistance zinc oxide.

16. The thin-film solar cell according to any of Claims 13 to 15, **characterised in that** the semiconductor absorber layer is, or comprises, a quaternary IB-IIIA-VIA-chalcopyrite layer, in particular a Cu(In, Ga)Se₂ layer, a penternary IB-IIIA-VIA chalcopyrite layer, in particular a Cu(In, Ga)(Se₁₋ₓ, Sₓ)₂ layer, or a kesterite layer, in particular a Cu₂ZnSn(Seₓ, S₁₋ₓ)₄ layer, wherein the value of x is from 0 to 1, and/or the average thickness of the semiconductor absorber layer is in the range of 400 nm to 2500 nm, in particular in the range of 500 nm to 1500, and preferably in the range of 800 nm to 1200 nm.

17. The photovoltaic thin-film solar module, containing at least two, in particular a plurality of thin-film solar cells, in particular ones that are monolithically integrated and series-connected, according to any of Claims 13 to 16.

18. The u of the multi-layer back electrode according to any of Claims 1 to 12 for the production of thin-film solar cells or thin-film solar modules.

19. The use according to Claim 18 of the multi-layer back electrode according to any of Claims 9 to 12 for doping a semiconductor absorber layer with a dopant, in particular selected from a sodium compound, sodium ions, a sodium molybdenum bronze and/or a sodium tungsten bronze during the production of a photovoltaic thin-film solar cell, in particular according to any of Claims 13 to 16, or a photovoltaic thin-film module, in particular according to Claim 17.

20. Method for producing a photovoltaic thin-film solar cell according to any of Claims 13 to 16, or a photovoltaic thin-film solar module according to Claim 17, comprising the steps of: applying the bulk back electrode layer (4), the barrier layer, the contact layer (8c), the metals of the semiconductor absorber layer and/or a dopant or dopants by physical thin-film deposition methods in particular comprising physical vapour deposition (PVD), vapour deposition using an electron beam evaporator, vapour deposition using a resistance evaporator, induction evaporation, arc evaporation and/or cathode sputtering (sputter coating), in particular DC or RF magnetron sputtering, preferably in a high vacuum in each case, or by chemical vapour deposition methods in particular comprising chemical vapour deposition (CVD), low pressure CVD, and/or atmospheric pressure.

21. The method according to Claim 20, **characterised in that** the dopant or dopants are in particular selected from a sodium compound, sodium ions, a sodium molybdenum bronze and/or a sodium tungsten bronze, and are applied together with at least one component of the contact layer (8c) and/or the absorber layer, in particular from a common mixed or sinter target.

## Revendications

1. Électrode arrière multicouche (1) pour une cellule photovoltaïque en couches minces, comprenant, dans cet ordre,
au moins une couche d'électrode arrière en volume (4), comprenant du, ou se composant de, V, Mn, Cr, Mo, Co, Zr, Ta, Nb et/ou W, et/ou comprenant des alliages, ou se composant d'alliages, lesquels comprennent V, Mn, Cr, Mo, Co, Zr, Fe, Ni, Al, Ta, Nb et/ou W,
au moins une couche barrière conductrice (6),
au moins une couche de contact (8c), en particulier ohmique,
comprenant au moins une première couche (10), voisine de la couche barrière (6), en Mo, W, Ta, Nb, Zr et/ou Co, en particulier Mo et/ou W, et
au moins une deuxième couche (12), non voisine de la couche barrière (6), comprenant, ou se composant de, au moins un chalcogénure métallique.

2. Électrode arrière multicouche (1) selon la revendication 1, **caractérisée en ce que** l'électrode arrière en volume et la couche de contact (8c) comprennent du molybdène ou du tungstène ou un alliage de molybdène ou un alliage de tungstène.

3. Électrode arrière multicouche (1) selon la revendication 1 ou 2, **caractérisée en ce que** la couche barrière (6) représente une barrière pour des composants migrant, en particulier diffusant ou pouvant être diffusés hors de et/ou par la couche d'électrode arrière en volume (4), et/ou pour des composants migrant, en particulier diffusant ou pouvant être diffusés hors de et/ou par la couche de contact (8c).

4. Électrode arrière multicouche (1) selon l'une quelconque des revendications précédentes, **caractérisée en ce que** la couche barrière (6) représente une barrière pour des ions alcalins, en particulier des ions sodium, du sélénium ou des composés de sélénium, du soufre ou des composés de soufre, des métaux, en particulier Cu, In, Ga, Fe, Ni, Ti, Zr, Hf, V, Nb, Ta, Al et/ou W, et/ou des composés comprenant des ions alcalins.

5. Électrode arrière multicouche (1) selon l'une quelconque des revendications précédentes, **caractérisée en ce que** la couche barrière (6) comprend, ou est formée de, au moins un nitrure métallique, en particulier TiN, MoN, TaN, ZrN et/ou WN, au moins un carbure métallique, au moins un borure métallique et/ou au moins un nitrure de silicium métallique, en particulier TiSiN, TaSiN et/ou WSiN.

6. Électrode arrière multicouche (1) selon l'une quelconque des revendications précédentes, **caractérisée en ce que** la couche d'électrode arrière en volume (4) est contaminée par au moins un élément sélectionné parmi le groupe se composant de Fe, Ni, Ti, Zr, Hf, V, Nb, Ta, W, Al et/ou Na et/ou par des composés desdits éléments.

7. Électrode arrière multicouche (1) selon l'une quelconque des revendications précédentes, **caractérisée en ce que** le métal du chalcogénure métallique de la couche de contact (8c) ou de la deuxième couche (12) de la couche de contact (8c) est sélectionné parmi le groupe se composant de molybdène, tungstène, tantale, zirconium, cobalt et/ou niobium, et **en ce que** le chalcogène du chalcogénure métallique est sélectionné parmi le groupe se composant de sélénium et/ou de soufre, le chalcogénure métallique représentant en particulier MSe₂ MS₂ et/ou M(Se₁₋ₓ, Sₓ)₂, avec M = Mo, W, Ta, Zr, Co ou Nb, x prenant des valeurs de 0 à 1.

8. Électrode arrière multicouche (1) selon l'une quelconque des revendications précédentes, **caractérisée en ce que** le métal de la première couche (10) et le métal de la deuxième couche (12) de la couche de contact (8c) correspondent entre eux, et/ou **en ce que** le métal de la première couche (10) et/ou le métal de la deuxième couche (12) de la couche de contact (8c) correspondent au métal de l'électrode arrière en volume.

9. Électrode arrière multicouche (1) selon l'une quelconque des revendications précédentes, **caractérisée en ce que** la couche de contact (8c), la première et/ou la deuxième couche (10, 12) de la couche de contact (8c) présentent au moins un dopant pour une couche absorbante semi-conductrice d'une cellule solaire en couches minces, en particulier au moins un élément sélectionné parmi le groupe se composant de sodium, potassium et lithium et/ou au moins un composé de ces éléments, de préférence avec de l'oxygène, du sélénium, du soufre, du bore et/ou des halogènes, par exemple de l'iode ou du fluor, et/ou au moins un bronze de métal alcalin, en particulier du bronze de sodium et/ou du bronze de potassium, de préférence avec un métal sélectionné parmi le groupe se composant de molybdène, tungstène, tantale et/ou niobium.

10. Électrode arrière multicouche (1) selon l'une quelconque des revendications précédentes, **caractérisée en ce que** l'épaisseur moyenne de la couche d'électrode arrière en volume (4) se trouve dans la plage de 50 nm à 500 nm, en particulier dans la plage de 80 nm à 250 nm, et/ou celle de la couche barrière (6) se trouve dans la plage de 10 nm à 250 nm, en particulier dans la plage de 20 nm à 150 nm, et/ou celle de la couche de contact (8c) se trouve dans la plage de 2 nm à 200 nm, en particulier dans la plage de 5 nm à 100 nm.

11. Électrode arrière multicouche (1) selon l'une quelconque des revendications précédentes, **caractérisée en ce que** la couche d'électrode arrière en volume (4) comprend du molybdène et/ou du tungstène, en particulier du molybdène, ou est essentiellement formée de molybdène et/ou de tungstène, en particulier de molybdène, **en ce que** la couche barrière conductrice (6) comprend du TiN ou est essentiellement formée en TiN, et
**en ce que** la couche de contact, en particulier comprenant un/des dopant(s), comprend du MoSe₂ ou est essentiellement formée en MoSe₂.

12. Électrode arrière multicouche (1) selon l'une des revendications 9 à 11, **caractérisée en ce que** le dopant, en particulier des ions sodium, est présent dans la couche de contact (8c) à une teneur dans la plage de 10¹³ à 10¹⁷ atomes/cm², en particulier dans la plage de 10¹⁴ à 10¹⁶ atomes/cm².

13. Cellule photovoltaïque en couches minces, comprenant au moins une électrode arrière multicouche (1) selon l'une quelconque des revendications précédentes.

14. Cellule solaire en couches minces selon la revendication 13, comprenant, dans cet ordre, au moins une couche de substrat (2), au moins une électrode arrière multicouche selon l'une des revendications 1 à 12, au moins une couche barrière conductrice (6), au moins une couche absorbante semi-conductrice, en particulier directement appliquée sur la couche de contact (8c), en particulier une couche absorbante semi-conductrice de chalcopyrite ou de kësterite, et au moins une électrode frontale,

15. Cellule solaire en couches minces selon la revendication 14, **caractérisée en ce qu'**au moins une couche tampon, en particulier au moins une couche, comprenant du, ou formée essentiellement de, CdS ou d'une couche dépourvue de CdS, en particulier contenant du, ou formée essentiellement de, Zn(S, OH) ou In₂S₃, et/ou au moins une couche, comprenant du, ou essentiellement formée d'oxyde de zinc intrinsèque et/ou d'oxyde de zinc avec résistance élevée, se trouve entre la couche absorbante semi-conductrice et l'électrode frontale.

16. Cellule solaire en couches minces selon l'une des revendications 13 à 15, **caractérisée en ce que** la couche d'absorption semi-conductrice représente ou comprend une couche de chalcopyrite IB-IIIA-VIA quaternaire, en particulier une couche de Cu(In, Ga)Se₂, une couche de chalcopyrite IB-IIIA-VIA quinternaire, en particulier une couche de Cu(In, Ga)(Se₁₋ₓ, Sₓ)₂, ou une couche de kësterite, en particulier une couche de Cu₂ZnSn(Seₓ, S₁₋ₓ)₄, x prenant des valeurs de 0 à 1, et/ou **en ce que** l'épaisseur moyenne de la couche absorbante semi-conductrice se trouve dans la plage de 400 nm à 2500 nm, en particulier dans la plage de 500 nm à 1500 nm, et de préférence dans la plage de 800 nm à 1200 nm.

17. Cellule photovoltaïque en couches minces, comprenant au moins deux, en particulier une pluralité de, cellules solaires en couches minces en particulier monolithiques intégrés en série selon l'une des revendications 13 à 16.

18. Utilisation de l'électrode arrière multicouche selon l'une des revendications 1 à 12 pour la fabrication de cellules solaires en couches minces ou de modules solaires en couches minces.

19. Utilisation selon la revendication 18 de l'électrode arrière multicouche selon l'une des revendications 9 à 12 pour le dopage d'une couche absorbante semi-conductrice avec un dopant, en particulier sélectionné parmi le groupe se composant de composés de sodium, ions sodium, un bronze de sodium-molybdène et/ou un bronze de sodium-tungstène, pendant la fabrication d'une cellule photovoltaïques en couches minces, en particulier selon l'une des revendications 13 à 16, ou d'un module photovoltaïques en couches minces, en particulier selon la revendication 17.

20. Procédé pour la fabrication d'une cellule photovoltaïque en couches minces selon l'une des revendications 13 à 16 ou d'un module photovoltaïque en couches minces selon la revendication 17, comprenant les étapes:
application de la couche d'électrode arrière en volume (4), de la couche barrière, de la couche de contact (8c), des métaux de la couche absorbante semi-conductrice et/ou d'un dopant/de dopants au moyen d'un procédé physique de dépôt de couches minces, en particulier au moyen d'un revêtement par dépôt physique en phase vapeur (PVD - Physical Vapour Deposition), dépôt physique en phase vapeur par faisceau d'électrons, dépôt par évaporateur thermique, évaporation par induction, évaporation par arc et/ou pulvérisation cathodique (revêtement par pulvérisation),
en particulier pulvérisation magnétron DC ou RF, respectivement de préférence sous vide poussé, ou par dépôt chimique en phase vapeur, comprenant en particulier le dépôt chimique en phase vapeur (CVD - Chemical Vapour Disposition), le CVD à basse pression (low pressure) et/ou à pression atmosphérique (atmospheric pressure).

21. Procédé selon la revendication 20, **caractérisé en ce que** le dopant/les dopants, en particulier sélectionné(s) parmi le groupe se composant d'un composé de sodium, d'ions sodium, d'un bronze de sodium-molybdène et/ou d'un bronze de sodium-tungstène, sont appliqués conjointement avec au moins un composant de la couche de contact (8c) et/ou de la couche absorbante, en particulier d'une cible mixte ou frittée commune.
